(19) **Europäisches Patentamt / European Patent Office / Office européen des brevets**

(11) **EP 3 264 119 A1**

(12) # EUROPEAN PATENT APPLICATION
published in accordance with Art. 153(4) EPC

(43) Date of publication:
**03.01.2018 Bulletin 2018/01**

(21) Application number: **15882616.4**

(22) Date of filing: **19.02.2015**

(51) Int Cl.:
***G01R 31/36*** *(2006.01)*

(86) International application number:
**PCT/JP2015/054650**

(87) International publication number:
**WO 2016/132514 (25.08.2016 Gazette 2016/34)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Kabushiki Kaisha Toshiba, Inc.**
**Tokyo 105-8001 (JP)**

(72) Inventors:
• **IDE Makoto**
**Tokyo 105-8001 (JP)**

• **MIZUTANI Mami**
**Tokyo 105-8001 (JP)**
• **MONDEN Yukitaka**
**Tokyo 105-8001 (JP)**
• **KOBAYASHI Takenori**
**Tokyo 105-8001 (JP)**
• **TANNO Tsutomu**
**Tokyo 105-8001 (JP)**

(74) Representative: **Awapatent AB**
**Junkersgatan 1**
**582 35 Linköping (SE)**

(54) **ELECTRICITY STORAGE SYSTEM, ELECTRICITY STORAGE CONTROL METHOD, AND ELECTRICITY STORAGE CONTROL PROGRAM**

(57) A storage system according to an embodiment includes a storage battery, a first deriver, a second deriver, and a corrector. The storage battery performs charging and discharging of electricity. The first deriver derives a first state of charge (SOC) on the basis of a voltage of the storage battery when a current is not flowing to the storage battery. The second deriver derives a second SOC on the basis of a battery capacity of the storage battery and an integrated value of a current flowing to the storage battery. The corrector corrects the battery capacity of the storage battery which is used by the second deriver on the basis of a difference between the second SOC derived by the second deriver and the first SOC derived by the first deriver after the derivation of the second SOC. Furthermore, the corrector changes a correction quantity of the correction in accordance with a state of the storage battery.

FIG. 1

# Description

[Technical Field]

Embodiments of the present invention relates to a storage system, a storage control method, and a storage control program.

[Background Art]

As technology for ascertaining the charging rate of a storage battery, technology for estimating a state of charge (SOC) serving as one of indexes of the charging rate on the basis of a ratio of a battery capacity of the storage battery to an amount of energy by which the storage battery is charged is known. However, since a battery capacity of a storage battery varies in accordance with a use status, aging, and the like of the storage battery, the estimation accuracy of an SOC may be lowered in some cases in a conventional estimation technique.

[Citation List]

[Patent Literature]

[Patent Literature 1]
Japanese Unexamined Patent Application, First Publication No. 2000-306613
[Patent Literature 2]
Japanese Unexamined Patent Application, First Publication No. 2014-174050

[Summary of Invention]

[Technical Problem]

An objective to be solved by the present invention is to provide a storage system, a storage control method, and a storage control program which can estimate an SOC of a storage battery with high accuracy.

[Solution to Problem]

A storage system in an embodiment includes a storage battery, a first deriver, a second deriver, and a corrector. The storage battery performs charging and discharging of electricity. The first deriver derives a first state of charge (SOC) on the basis of a voltage of the storage battery when a current is not flowing to the storage battery. The second deriver derives a second SOC on the basis of a battery capacity of the storage battery and an integrated value of a current flowing to the storage battery. The corrector corrects the battery capacity of the storage battery which is used by the second deriver on the basis of a difference between the second SOC derived by the second deriver and the first SOC derived by the first deriver after the derivation of the second SOC. Furthermore, the corrector changes a correction quantity of the correction in accordance with a state of the storage battery.

[Brief Description of Drawings]

Fig. 1 is a diagram illustrating an example of a constitution of a storage system 1 according to a first embodiment.
Fig. 2 is a diagram illustrating an example of an application of the storage system 1 according to the first embodiment.
Fig. 3 is a diagram showing a change in state of charge (SOC) calculated before and after charging and discharging of electricity.
Fig. 4 is a diagram used for comparing an $SOC_2$# derived using a battery capacity C# after correction and an $SOC_2$ derived using a battery capacity C before correction.
Fig. 5 is a flowchart for describing an example of a process performed by the storage system 1 according to the first embodiment.
Fig. 6 is a diagram illustrating an example of a correspondence between a current rate R and a reduction rate of a $\Delta SOC$.
Fig. 7 is a diagram illustrating another example of a correspondence between the current rate R and the reduction rate of the $\Delta SOC$.
Fig. 8 is a diagram illustrating yet another example of a correspondence between the current rate R and the reduction rate of the $\Delta SOC$.
Fig. 9 is a diagram illustrating still another example of a correspondence between the current rate R and the reduction rate of the $\Delta SOC$.
Fig. 10 is a diagram illustrating still another example of a correspondence between the current rate R and the reduction rate of the $\Delta SOC$.
Fig. 11 is a diagram illustrating still another example of a correspondence between the current rate R and the reduction rate of the $\Delta SOC$.
Fig. 12 is a diagram illustrating an example of a correspondence between a $\Delta SOC$ derived by a Comparator and corrector 36 and a reduction rate of a $\Delta SOC$.
Fig. 13 is a flowchart for describing an example of a process performed by a Comparator and corrector 36 according to a second embodiment.
Fig. 14 is a diagram illustrating an example of a constitution of a storage system 1 according to a third embodiment.
Fig. 15 is a diagram illustrating an example of a correspondence between a temperature T and a reduction rate of a $\Delta SOC$.

[Description of Embodiments]

A storage system, a storage control method, and a storage control program according to an embodiment will be described below with reference to the drawings.

(First embodiment)

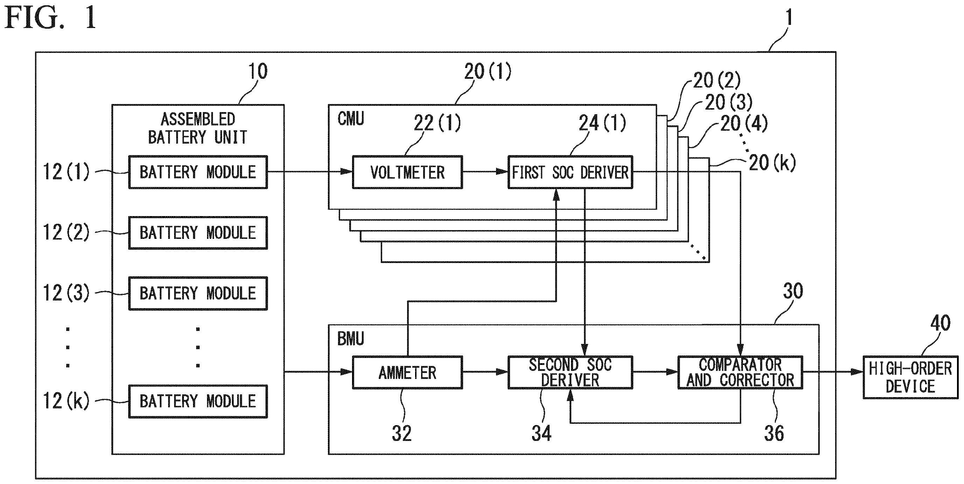

Fig. 1 is a diagram illustrating an example of a constitution of a storage system 1 according to a first embodiment. The storage system 1 includes an assembled battery unit 10 including a plurality of battery modules 12(1) to 12(k), a plurality of cell monitoring units (CMUs; battery monitoring units) 20(1) to 20(k), and a battery managing unit (BMU; a battery managing unit) 30. Such constituent elements are connected to each other using controller area network (CAN) cables (not shown).

The battery modules 12(1) to 12(k) include, for example, secondary batteries such as lithium ion batteries, lead storage batteries, sodium sulfur batteries, redox flow batteries, and nickel metal hydride batteries. The characteristics of the secondary batteries are represented by, for example, parameters including a battery capacity C [Ah] and a current rate R [C]. For example, in a battery with a rated battery capacity of 20 [Ah], a current with a current rate of 1[C] (20 [A]) can be discharged for one hour at a time of a state of charge (SOC) of 100% (fully charged) in a state in which deterioration does not occur such as immediately after shipment. In other words, a current with a current rate of 1[C] (20 [A]) can be charged for one hour at a time of an SOC of 0% in a state in which deterioration does not occur such as immediately after shipment.

Hereinafter, when the plurality of battery modules 12(1) to 12(k) are not distinguished, the plurality of battery modules 12(1) to 12(k) are simply referred to as battery modules 12. Furthermore, when the plurality of CMUs 20(1) to 20(k) are not distinguished, the plurality of CMUs 20(1) to 20(k) are simply referred to as CMUs 20. The CMUs 20(1) to 20(k) have the same constitution, and the CMUs are provided in accordance with the number k of battery modules.

The storage system 1 switches battery modules to be operated among the battery modules 12(1) to 12(k) on the basis of a charge and discharge electric power command sent form a high-order device 40. The storage system 1 charges and discharges the selected assembled battery unit 10 on the basis of the charge and discharge electric power command. Note that it is desirable to charge and discharge the battery modules 12 using a constant current. In this embodiment, charging and discharging of electricity performed using a constant current will be described below as an example.

The BMU 30 derives an SOC as one of indexes of a charging rate of each battery module 12 in accordance with an operation status of the assembled battery unit 10. A method of deriving the SOC performed using the BMU 30 will be described below.

Note that an SOC may be derived in the high-order device 40 or the CMU 20 instead of the SOC being derived in the BMU 30, and two or more processors included in the high-order device 40, the BMU 30, and the CMU 20 may be configured to bear a part of an arithmetic process of deriving an SOC.

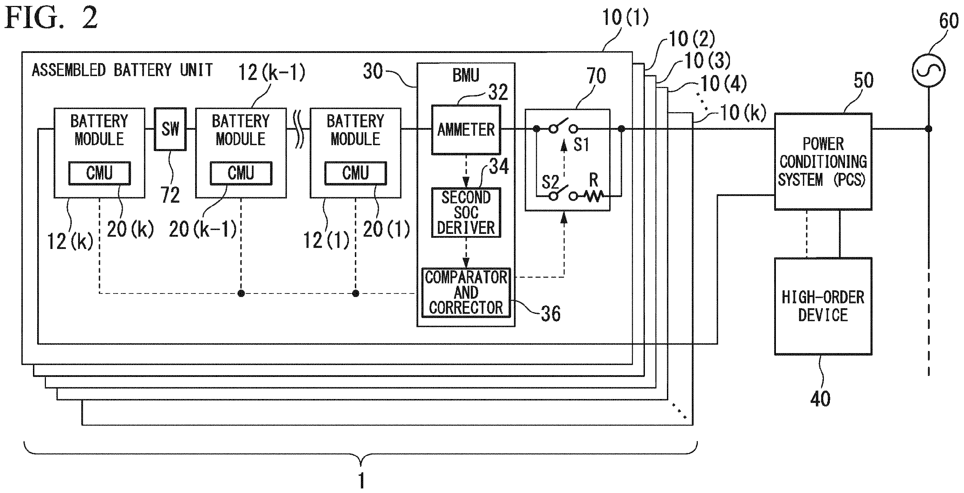

Fig. 2 is a diagram illustrating an example of an application of the storage system 1 according to the first embodiment. In Fig. 2, a solid line and a broken line indicate an electric power line and a communication line, respectively. It is desirable that the storage system 1 includes a plurality of assembled battery units 10(1) to 10(k) to correspond to various charge and discharge electric power commands. In Fig. 2, an inside of only an assembled battery unit 10(1) serving as one of a plurality of assembled battery units 10 is illustrated. A description will be provided below focusing on a constitution of the assembled battery unit 10(1).

The storage system 1 is connected to, for example, an electric power system 60, the high-order device 40, a power conditioning system (PCS) 50, and the like. The high-order device 40 sends the charge and discharge electric power command sent to the assembled battery unit 10 controlled by the PCS 50 to the PCS 50.

The PCS 50 includes a processor such as a central processing unit (CPU), a communication interface configured to bi-directionally communicate with the high-order device 40, and the like. The PCS 50 performs the following operations on the basis of a control signal sent from the high-order device 40. For example, the PCS 50 converts direct current (DC) electric power discharged from the battery module 12 into alternating current (AC) electric power, and steps up a voltage to a voltage (for example, 3.3 to 6.6 [kV]) used in an electric power system. Furthermore, for example, the PCS 50 converts AC electric power supplied from the electric power system into DC electric power, and steps down a voltage to a voltage (for example, 100 [V]) by which the battery module 12 can be charged.

A series circuit in which a plurality of battery modules 12, the BMU 30, a switch circuit 70, and switches 72 are connected in series to each other is constituted inside the assembled battery unit 10(1). The assembled battery unit 10(1) is connected to one terminal of the series circuit and the PCS 50 with the switch circuit 70. In the switch circuit 70, for example, a switch S1 having no resistance (having, for example, a resistance value which is 1/10 or less that of a resistor R) and a switch S2 connected in series to the resistor R are connected in parallel to each other.

Also, the switches 72 may be provided between the battery modules 12. Each of the switches 72 is used for turning off the series circuit, for example, when any of the battery modules 12 is removed therefrom for the purpose of checking the battery module 12. The switch 72 is also used as a disconnecting unit (a service disconnect) in some cases and also functions as a fuse in some cases. In this case, wires used to notify the BMU 30 of an inserted and removal state and a state of fusing may be provided.

The BMU 30 includes, for example, a processor such as a CPU and a storage unit such as a read only memory (ROM), a random access memory (RAM), a flash memory, and a hard disk drive (HDD). The BMU 30 appropriately controls the switch circuit 70 and the switch 72 on the basis of the charge and discharge electric power command. The BMU 30 controls the switch circuit 70 such that the number of battery modules 12 and the number of assembled battery units 10 configured to charge and discharge are adjusted, for example, such that an amount of charging and discharging of electricity contained in the charge and discharge electric power command is satisfied.

Constitutions will be described in detail below by referring back to Fig. 1.

Each of The CMUs 20(1) to 20(k) includes, for example, voltmeters 22(1) to 22(k) and first SOC derivers 24(1) to 24(k). Hereinafter, when the plurality of voltmeters 22(1) to 22(k) are not distinguished, the plurality of voltmeters 22(1) to 22(k) are simply referred to as voltmeters 22, and when the plurality of first SOC derivers 24(1) to 24(k) are not distinguished, the plurality of first SOC derivers 24(1) to 24(k) are simply referred to as first SOC derivers 24. The voltmeters 22 each measure voltages between positive electrode and negative electrode terminals in the battery modules 12.

Each of the first SOC derivers 24 acquires information indicating a voltage of each of the battery modules 12 from each of the voltmeters 22 at a timing at which each of the voltages is static and derives a first SOC. The timing at which the voltage is static is a time at which a voltage between terminals of the battery modules 12 is sufficiently stabilized and an open-circuit voltage which will be described below can be measured. The first SOC deriver 24 calculates a first SOC at both a timing at which a voltage is static before charging and discharging of electricity and a timing at which the voltage is static after the charging and discharging of electricity. The first SOC deriver 24 is an example of a "first deriver." Note that the first SOC derivers 24(1) to 24(k) may be functional units of the BMU 30.

The first SOC deriver 24 determines that a voltage of the battery module 12 is static, for example, when a predetermined time $\Delta t$ (for example, 10 minutes) has elapsed from a timing at which the charging and discharging of electricity has been completed and acquires information indicating the voltage of the battery modules 12 from the voltmeter 22. Note, when subsequent charging and discharging of electricity is started when a predetermined time $\Delta t$ has not elapsed from the timing at which the charging and discharging of electricity has been completed, no first SOC derivers 24 acquire a voltage in the meantime.

The first SOC deriver 24 determines that the charging and discharging of electricity has been completed when a current measured by a ammeter 32 exceeds a threshold value Iref (for example, 0.1 [mA]), and determines that the charging and discharging of electricity has not been completed when the current measured thereby is the threshold value Iref or less. Hereinafter, the voltage acquired at the timing at which the voltage is static is referred to as a "static voltage."

Any timing may be used for a timing at which the static voltage is acquired as long as charging and discharging of electricity following corresponding charging and discharging of electricity is performed within a period before a scheduled time. Furthermore, a static voltage may be acquired multiple times within this period such that an average value is derived from a plurality of static voltages.

Also, the first SOC deriver 24 acquires open-circuit voltage (OCV)-SOC characteristics data from a storage unit (not shown) to derive an SOC. The OCV-SOC characteristics data is data indicating a correlation of an OCV and an SOC of the storage battery included in the battery module 12.

The first SOC deriver 24 applies the acquired static voltage to the OCV-SOC characteristics data to derive an SOC (a first SOC) of the battery modules 12. Hereinafter, for convenience, a first SOC derived on the basis of a static voltage acquired before the charging and discharging of electricity performed at any timing is referred to as an "$SOC_{1b}$." Furthermore, similarly, a first SOC derived on the basis of a static voltage acquired after the charging and discharging of electricity is referred to as an "$SOC_{1a}$." When the first SOCs are derived, the first SOC deriver 24 sends the first SOCs to the BMU 30.

The BMU 30 includes, for example, the ammeter 32, a second SOC deriver 34, and a Comparator and corrector 36. The ammeter 32 measures a current flowing to the battery module 12 for every battery module 12.

The second SOC deriver 34 derives an SOC (a second SOC) of the battery module 12 on the basis of an integrated value (hereinafter referred to as a "current integrated value $\int I$") of a current flowing to the battery module 12 during the charging and discharging of electricity, a battery capacity C of the battery module 12, and an $SOC_{1b}$ derived by the first SOC deriver 24. Hereinafter, the SOC derived by the second SOC deriver 34 is referred to as an "$SOC_2$." Note that the second SOC deriver 34 is an example of a "second deriver."

The second SOC deriver 34 calculates a current integrated value $\int I$ (for example, a unit is [Ah]), for example, using a period between an integration start time at which a current flowing to the battery module 12 has changed from a state in which the current is the threshold value Iref or less to a state in which the current exceeds the threshold value Iref and an integration end time at which the current flowing to the battery module 12 has changed from a state in which the current exceeds the threshold value Iref to a state in which the current is the threshold value Iref or less as an integration period. The second SOC deriver 34 divides the calculated current integrated value ∫I by the battery capacity C of the battery module 12, adds the $SOC_{1b}$ derived by the first SOC deriver 24 to a value obtained by expressing the value obtained by this division as a percentage, and derives an $SOC_2$. The second SOC deriver 34 outputs the calculated current integrated value ∫I to the Comparator and corrector 36.

[Expression. 1]

$$SOC_2 = \frac{\int I}{C} \times 100 + SOC_{1b} \qquad \cdots (1)$$

The first SOC deriver 24 derives an $SOC_{1a}$ on the basis of, for example, the static voltage acquired at the timing at which the predetermined time Δt has elapsed from the integration end time.

The Comparator and corrector 36 derives a difference ΔSOC between the $SOC_2$ derived by the second SOC deriver 34 and the $SOC_{1a}$ derived by the first SOC deriver 24. The Comparator and corrector 36 corrects parameters associated with the battery capacity C of the battery module 12 so that a value of a ΔSOC is set to 0 when the derived ΔSOC is not 0. Note that the Comparator and corrector 36 is an example of a "corrector."

The Comparator and corrector 36 corrects the parameters of the battery capacity C of the battery module 12 in a derivation equation of the $SOC_2$ so that an $SOC_2$ derived next time coincides with the $SOC_{1a}$ using the $SOC_{1a}$ as a true value, for example, when the ΔSOC is not 0. In other words, the storage system 1 derives the $SOC_2$ using the corrected battery capacitor C (hereinafter referred to a "battery capacity C#" at a time at which electricity is charged and discharged after the charging and discharging of electricity. Thus, the storage system 1 can improve estimation accuracy of the SOC of the battery module 12. Note that the Comparator and corrector 36 may decide whether to perform correction, for example, in accordance with whether an absolute value of the ΔSOC has exceeded a threshold value (for example, 5%) or the like instead of deciding whether to perform correction in accordance with whether the ΔSOC is 0. The same applies to the following description.

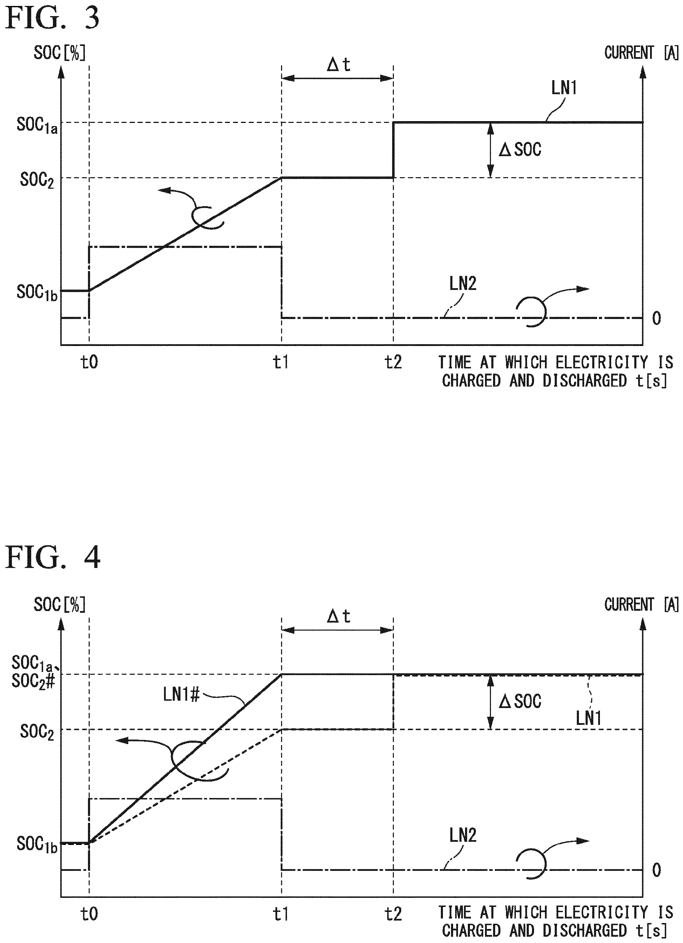

A process of correcting a parameter of a battery capacity C will be described below with reference to Figs. 3 and 4. Fig. 3 is a diagram showing a change in SOC calculated before and after the charging and discharging of electricity. LN1 illustrated in Fig. 3 indicates the change in SOC derived by the first SOC deriver 24 or the second SOC deriver 34. Furthermore, LN2 indicates a current measured by the ammeter 32. In Fig. 3, a left vertical axis indicates SOC [%], a right vertical axis indicates a current [A], and a horizontal axis indicates a charge and discharge time t [s].

Hereinafter, it is assumed that charging and discharging of electricity starts at time to, and the charging and discharging of electricity ends at time $t_1$. In this case, the second SOC deriver 34 derives an $SOC_2$ on the basis of a current integrated value ∫I in a period from time to to time $t_1$, the battery capacity C of the battery module 12, and an $SOC_{1b}$ derived by the first SOC deriver 24 on the basis of a static voltage before time to.

The first SOC deriver 24 acquires a static voltage of the battery module 12 at time $t_2$ at which a predetermined time Δt or more has elapsed from time $t_1$ at which the charging and discharging of electricity has ended. The first SOC deriver 24 derives an $SOC_{1a}$ of the battery module 12 after the charging and discharging of electricity on the basis of the acquired static voltage and OCV-SOC characteristics data.

The Comparator and corrector 36 derives a difference ΔSOC between the $SOC_2$ derived by the second SOC deriver 34 and the $SOC_{1a}$ derived by the first SOC deriver 24. Since the ΔSOC is not 0 in the illustrated example, the Comparator and corrector 36 corrects the parameters associated with the battery capacity C of the battery module 12, and notifies the second SOC deriver 34 that parameters of a battery capacity C# after the correction have changed. The battery capacity C# after the correction is derived using the following Expression (2).

[Expression. 2]

$$C\# = \frac{\int I}{(SOC_{1a} - SOC_{1b})} \times 100 \qquad \cdots (2)$$

Fig. 4 is a diagram used for comparing an $SOC_2\#$ derived using a battery capacity C# after correction and an $SOC_2$ derived using a battery capacity C before correction. LN1# illustrated in Fig. 4 indicates the $SOC_2\#$ derived using the battery capacity C# after the correction. Furthermore, LN1 indicates an $SOC_2$ and an $SOC_{1a}$ derived using the battery capacity C before the correction. As illustrated in Fig. 4, the $SOC_2\#$ is corrected at time t2 such that the $SOC_2\#$ coincides with the $SOC_{1a}$. Note that an LN2, a left vertical axis, a right vertical axis, and a horizontal axis illustrated in Fig. 4 are the same as those of Fig. 3.

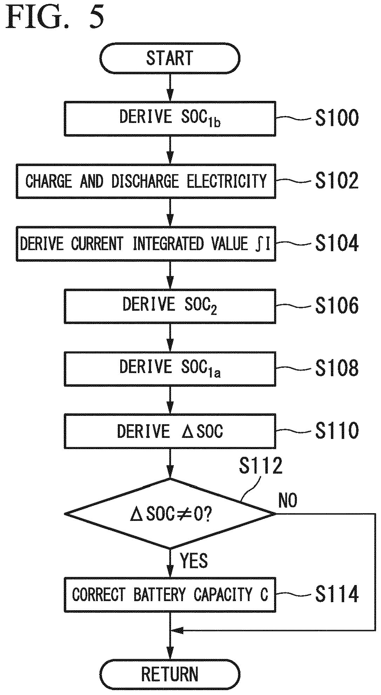

Fig. 5 is a flowchart for describing an example of a process performed by the storage system 1 according to the first embodiment. A process of this flowchart is repeatedly performed for each cycle, for example, using a period from a start to a stop of an operation of the battery module 12 as one cycle.

First, the first SOC deriver 24 acquires a static voltage of the battery module 12 from the voltmeter 22 at a timing at which a voltage is static before charging and discharging of electricity, and derives an $SOC_{1b}$ on the basis of the acquired static voltage and OCV-SOC characteristics data (Step S100). Subsequently, the storage system 1 charges and discharges the battery module 12 on the basis of the charge and discharge electric power command (Step S102).

Subsequently, the second SOC deriver 34 calculates a current integrated value $\int I$ of the battery module 12 during charging and discharging of electricity on the basis of measured results of the ammeter 32 (Step S104). Subsequently, the second SOC deriver 34 derives an $SOC_2$ on the basis of the calculated current integrated value $\int I$, the battery capacity C of the battery module 12, and the $SOC_{1b}$ derived by the first SOC deriver 24 (Step S106).

Subsequently, the first SOC deriver 24 acquires a static voltage of the battery module 12 from the voltmeters 22 at a timing at which the voltage is static after the charging and discharging of electricity, and derives an $SOC_{1a}$ on the basis of the acquired static voltage and OCV-SOC characteristics data (Step S108).

Subsequently, the Comparator and corrector 36 derives a difference $\Delta SOC$ between the $SOC_2$ derived by the second SOC deriver 34 and the $SOC_{1a}$ derived by the first SOC deriver 24 (Step S110).

Subsequently, the Comparator and corrector 36 determines whether the derived $\Delta SOC$ is not 0 (Step S112). The storage system 1 ends the process of this flowchart when it is determined that the derived $\Delta SOC$ is 0 (Step S112: NO). The Comparator and corrector 36 corrects the parameters of the battery capacity C of the battery module 12 so that a value of the $\Delta SOC$ is 0 (Step S114) when it is determined that the derived $\Delta SOC$ is not 0 (Step S112: YES). Thus, the storage system 1 ends the process of this flowchart.

According to the storage system 1 in the above-described first embodiment, the $SOC_{1b}$ is derived on the basis of the static voltage of the battery module 12 acquired at the time at which the voltage is static before the charging and discharging of electricity and the OCV-SOC characteristics data, the $SOC_2$ is derived on the basis of the current integrated value $\int I$ of the battery module 12 during the charging and discharging of electricity, the battery capacity C of the battery module 12, and the derived $SOC_{1b}$, the $SOC_{1a}$ is derived on the basis of the static voltage of the battery module 12 acquired at the timing at which the voltage is static after the charging and discharging of electricity and the OCV-SOC characteristics data, and the parameters of the battery capacity C of the battery module 12 are corrected on the basis of the difference $\Delta SOC$ between the $SOC_2$ and the $SOC_{1a}$. As a result, the storage system 1 can estimate the SOC of the battery module 12 with high accuracy.

(Second embodiment)

A storage system 1 in a second embodiment will be described below. In the storage system 1 in the second embodiment, functions of a Comparator and corrector 36 are different from those of the first embodiment. Therefore, description thereof will be provided focusing on associated differences, and description of the same parts will be omitted. Here, a process of the Comparator and corrector 36 will be described as one of differences from the first embodiment.

In the storage system 1 in this embodiment, a correction quantity to be corrected is appropriately changed on the basis of a use state of a battery module 12 when a battery capacity C is corrected on the basis of a $\Delta SOC$ derived by the Comparator and corrector 36. The use state includes, for example, (1) a current rate R at a time at which electricity is charged and discharged, (2) a derived $\Delta SOC$, and any one or more other states. In this embodiment, for example, a use state in which charging and discharging of electricity is performed using a current rate R of 1C and a constant current while an SOC of the battery module 12 is being changed from 100% to 0% is set as a reference state, and various parameters at that time are set as reference values. Hereinafter, a process of changing a correction quantity will be described with reference to the drawings.

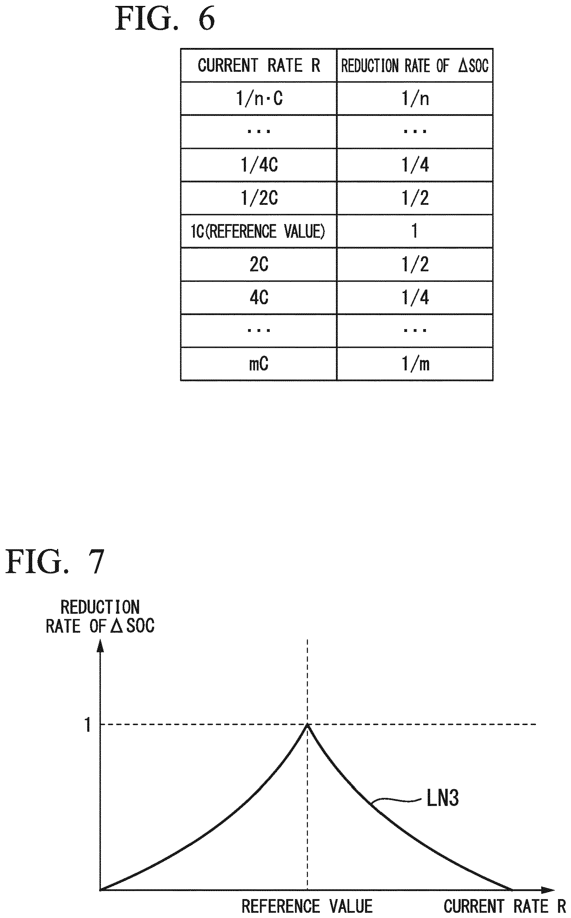

Fig. 6 is a diagram illustrating an example of a correspondence between a current rate R and a reduction rate of a $\Delta SOC$. The Comparator and corrector 36 evaluates the $\Delta SOC$ as being lower according to an interval between the current rate R and the reference value to reduce a correction quantity. In Fig. 6, the reduction rate of the $\Delta SOC$ is a rate at which a difference $\Delta SOC$ between an $SOC_{1a}$ and an $SOC_2$ is reduced, and is, for example, expressed as a coefficient multiplied by the $\Delta SOC$.

In an example of Fig. 6, in the case of the current rate R of 1C (the reference value), the reduction rate of the $\Delta SOC$ is set to, for example, 1. In other words, in the case of the current rate R of the reference value, the Comparator and corrector 36 corrects parameters of the battery capacity C of the battery module 12 so that the derived $\Delta SOC$ is 0.

Also, when the current rate R is 1/2C or 2C, the reduction rate of the $\Delta SOC$ is set to, for example, 1/2. In other words, when the current rate R is 1/2C or 2C, the Comparator and corrector 36 corrects the parameters of the battery capacity C of the battery module 12 so that a contribution rate associated with the correction quantity of the $\Delta SOC$ is 1/2 that of a case in which the current rate R is 1C.

Correspondences between the current rate R and the reduction rate of the $\Delta SOC$ may have relationships illustrated as in the graphs of Figs. 7 to 11. In this case, the correspondences are represented by, for example, an exponential function, a polynomial function, or the like in which the current rate R is set to a logarithmic axis and the reference value is axisymmetric. Hereinafter, the drawings will be described. In all of the drawings, vertical axes indicate the reduction rates of the $\Delta SOC$, and horizontal axes indicate the current rates R which are logarithmically expressed.

Fig. 7 is a diagram illustrating another example of a correspondence between the current rate R and the reduction rate of the $\Delta SOC$. LN3 illustrated in Fig. 7 is obtained by, for example, a function in which LN3 is axisymmetric with respect to a reference value and a reduction rate exponentially increases as the reduction rate approaches the reference value.

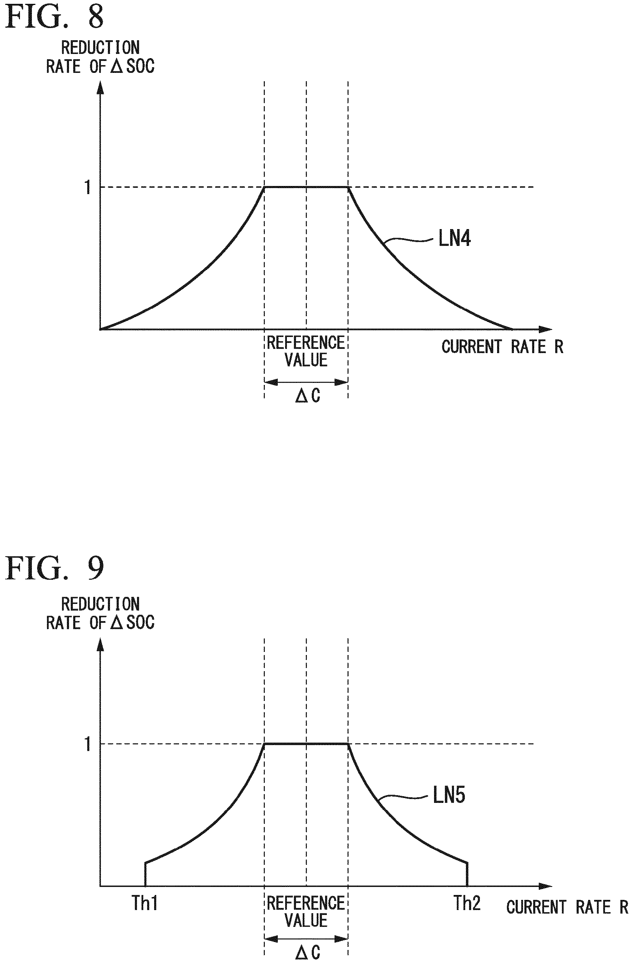

Fig. 8 is a diagram illustrating yet another example of a correspondence between the current rate R and the reduction rate of the ΔSOC. LN4 illustrated in Fig. 8 is obtained by a function in which the reduction rate is constant and LN4 is axisymmetric with respect to a reference value in a predetermined range ΔC centering on the reference value. LN4 is set such that the reduction rate is set to 1 in a predetermined range ΔC (for example, the current rate R is 0.8 to 1.2) and the reduction rate exponentially increases as the reduction rate approaches the reference value in other sections.

Fig. 9 is a diagram illustrating still another example of a correspondence between the current rate R and the reduction rate of the ΔSOC. LN5 illustrated in Fig. 9 is obtained by a function in which the reduction rate is constant in a predetermined range ΔC which is a threshold value Th1 or less and a threshold value Th2 or more and has a reference value centered thereon. In LN5, for example, the reduction rate is set to 1 in a predetermined range ΔC (for example, a current rate R is 0.8 to 1.2), and the reduction rate is set to 0 in a section which is the threshold value Th1 or less and the threshold value Th2 or more. Furthermore, LN5 is set so that the reduction rate exponentially increases as the reduction rate approaches the reference value in other sections.

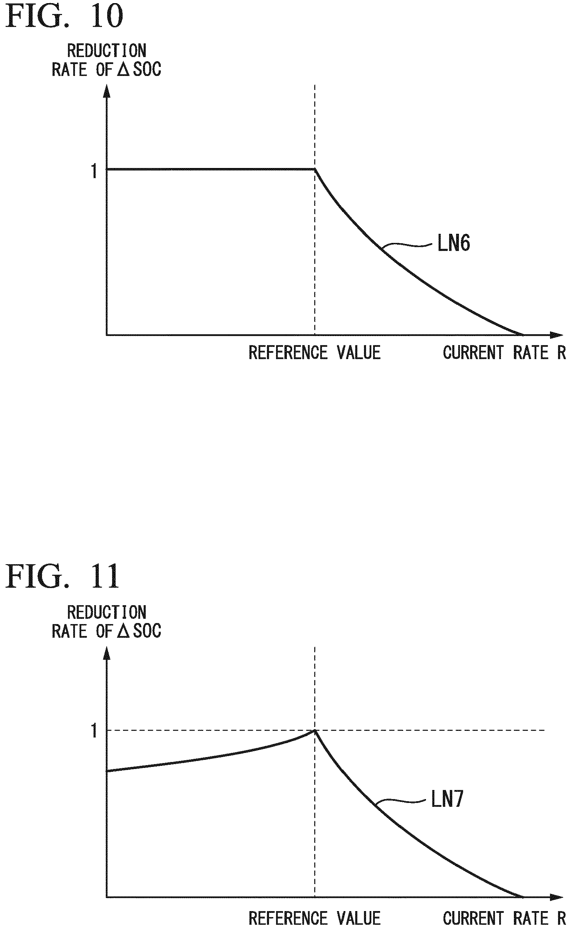

Fig. 10 is a diagram illustrating still another example of a correspondence between the current rate R and the reduction rate of the ΔSOC. LN6 illustrated in Fig. 10 is obtained by, for example, a function in which the reduction rate is constant in a section which is the reference value or less and the reduction rate decreases as the current rate R increases in a section which is the reference value or more. For example, LN6 is set so that the reduction rate is set to 1 in the section which is the reference value or less and the reduction rate exponentially decreases as the current rate R increases in the section which is the reference value or more.

Fig. 11 is a diagram illustrating still another example of a correspondence between the current rate R and the reduction rate of the ΔSOC. LN7 illustrated in Fig. 11 is obtained by a function in which the reduction rate in a section which is a reference value or less increases or decreases more gently than the reduction rate in a section in which the current rate R is a reference value or more. For example, LN7 is set such that a slope (for example, an index) indicating an increase and decrease is 0.5 in the section which is the reference value or less when the slope (for example, the index) indicating the increase and decrease in a section which is the reference value or more is 2.

Also, the Comparator and corrector 36 in this embodiment may perform a correction process of changing the reduction rate of the ΔSOC in accordance with the above-described current rate R as well as, for example, the Comparator and corrector 36 correcting the parameters of the battery capacity C of the battery module 12 in accordance with the derived ΔSOC. Hereinafter, description will be provided with reference to the drawings.

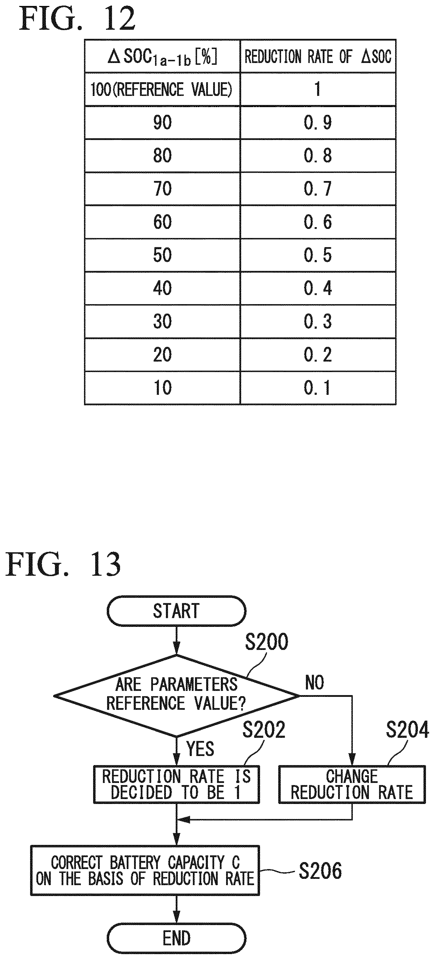

Fig. 12 is a diagram illustrating an example of a correspondence between a $\Delta SOC_{1a-1b}$ derived by a Comparator and corrector 36 and a reduction rate of a $\Delta SOC_{2-1a}$. Note that, here, the above-described ΔSOC is referred to as the $\Delta SOC_{2-1a}$, and description thereof will be described. The $\Delta SOC_{1a-1b}$ indicates a difference between the $SOC_{1a}$ and the $SOC_{1b}$. In other words, the $\Delta SOC_{1a-1b}$ is a difference between an SOC value after the charging and discharging of electricity calculated by the first SOC deriver 24 and an SOC value before the charging and discharging of electricity calculated by the first SOC deriver 24. Furthermore, the $\Delta SOC_{2-1a}$ indicates a difference between the $SOC_2$ and the $SOC_{1a}$. In other words, the $\Delta SOC_{2-1a}$ is a difference between an SOC value after the charging and discharging of electricity calculated by the second SOC deriver 34 and the SOC value after the charging and discharging of electricity calculated by the first SOC deriver 24.

In an example of Fig. 12, in the case of the $\Delta SOC_{1a-1b}$ of 100% (the reference value), the reduction rate of the $\Delta SOC_{2-1a}$ is set to 1. In other words, the Comparator and corrector 36 corrects the parameters of the battery capacity C of the battery module 12 so that the $\Delta SOC_{2-1a}$ is 0 when the derived $\Delta SOC_{1a-1b}$ is 100%. Furthermore, when the $\Delta SOC_{1a-1b}$ is 20%, a reduction rate of the $\Delta SOC_{2-1a}$ is set to, for example, 0.2. In other words, the Comparator and corrector 36 corrects the parameters of the battery capacity C of the battery module 12 so that the derived $\Delta SOC_{2-1a}$ becomes 4/5 when the $\Delta SOC_{1a-1b}$ is 20%. Note that it is assumed that the above-described data, functions, and the like indicating the various correspondences are stored in any storage unit (storage device) of the BMU 30, the CMU 20, the high-order device 40, and the like in advance.

Also, the Comparator and corrector 36 in this embodiment may decide the reduction rate of the ΔSOC on the basis of the current rate R and the derived ΔSOC. In this case, the Comparator and corrector 36 multiplies parameters of the current rate R and the ΔSOC by an associated reduction rate of the ΔSOC, and derives the values obtained by multiplication as the reduction rates of the ΔSOC. The Comparator and corrector 36 corrects the parameters of the battery capacity C of the battery module 12 such that the ΔSOC multiplied by the reduction rate is obtained.

The Comparator and corrector 36 derives a value (= 1/5) obtained by multiplying 1/4 and 0.8 as a reduction rate of the ΔSOC when the current rate R is 4C and the ΔSOC is 80%, for example, in numerical value examples of Figs. 6 and 12 described above. The Comparator and corrector 36 corrects the parameters of the battery capacity C of the battery module 12 so that the derived ΔSOC becomes 4/5.

Fig. 13 is a flowchart for describing an example of a process performed by the Comparator and corrector 36 according to the second embodiment. Note that a process of the flowchart corresponds to the process of Step S 114 of Fig. 5 described above.

First, the Comparator and corrector 36 determines whether the various parameters including the derived $\Delta$SOC and the current rate R are reference values (Step S200). The Comparator and corrector 36 decides a reduction rate by which the derived $\Delta$SOC is multiplied to be 1 when it is determined that the various parameters are the reference values (Step S200: YES) (Step S202). The Comparator and corrector 36 decides and changes a reduction rate by which the derived $\Delta$SOC is multiplied on the basis of any parameter which is not a reference value (Step S204) when it is determined that the various parameters are not the reference values (Step S200: NO).

Subsequently, the Comparator and corrector 36 corrects the parameters of the battery capacity C of the battery module 12 such that the $\Delta$SOC value is 0 or small on the basis of the decided reduction rate of the $\Delta$SOC (Step S206). Thus, the Comparator and corrector 36 ends the process of this flowchart.

According to the storage system 1 in the above-described second embodiment, a correction quantity of the battery capacity C is changed on the basis of the use state of the battery module 12 so that the SOC of the battery module 12 can be estimated with higher accuracy.

(Third embodiment)

A storage system 1 in a third embodiment will be described below. The storage system 1 in the third embodiment includes thermometers 26(1) to 26(k) in addition to the constituent elements included in the first or second embodiment. Hereinafter, description of functions the same as those of the first or second embodiment will be omitted.

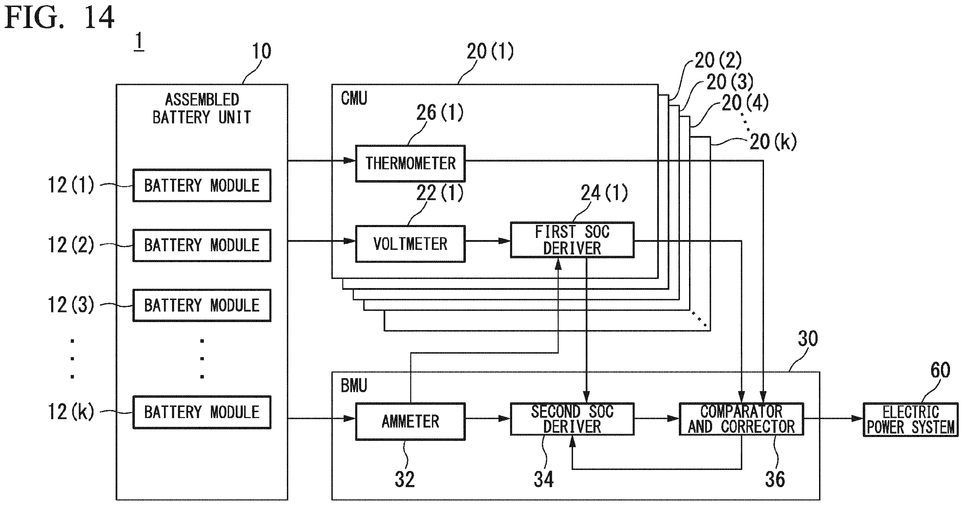

Fig. 14 is a diagram illustrating an example of a constitution of the storage system 1 according to the third embodiment. CMUs 20 each include a thermometer 26. Each of the thermometers 26 measures a temperature T [°C] of each of the battery modules 12. The temperature T includes, for example, a temperature near an outer surface of a housing (not shown) of the battery module 12, a temperature inside the battery module 12 estimated from the temperature near the outer surface, and the like.

The Comparator and corrector 36 acquires the temperature T of each of the battery modules 12 from the thermometer 26, and decides the reduction rate of the $\Delta$SOC on the basis of the acquired temperature T. The significance of reducing the $\Delta$SOC is the same as that of the second embodiment.

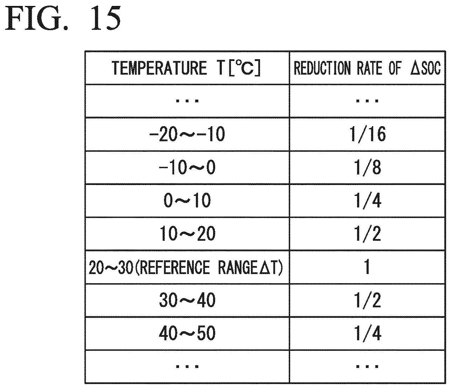

Fig. 15 is a diagram illustrating an example of a correspondence between a temperature T and a re-

duction rate of a $\Delta$SOC. In the third embodiment, a reference temperature T (a reference range $\Delta$T) in the use state of the battery module 12 is set to, for example, 20 to 30 °C. The Comparator and corrector 36 decides the reduction rate of the $\Delta$SOC to be 1 when a temperature T measured by the thermometer 26 is within the reference range $\Delta$T. Furthermore, the Comparator and corrector 36 decides the reduction rate of the $\Delta$SOC to be 1/2, for example, when the temperature T measured by the thermometer 26 is 10 to 20 °C or 30 to 40 °C. The Comparator and corrector 36 corrects parameters of the battery capacity C of the battery module 12 on the basis of the decided reduction rate.

Also, it is desirable that a correspondence between the temperature T and the reduction rate of the $\Delta$SOC is decided in consideration of a type of battery, individual differences, and the like of the battery module 12 to be used. For example, when the battery to be used is a lithium ion battery, a reduction rate is decided on the basis of temperature characteristics of the lithium ion battery. In the case of the lithium ion battery, for example, a reduction rate at a temperature less than 0 °C is reduced compared to a reduction rate at a temperature of 0 °C or higher. Thus, the SOC can be estimated for every battery module 12 to be used with higher accuracy. Note that it is assumed that data indicating the above-described correspondence is stored in any storage unit (a storage device) of a BMU 30, a CMU 20, a high-order device 40, and the like.

The Comparator and corrector 36 in this embodiment may decide a reduction rate of a $\Delta$SOC on the basis of a current rate R, the $\Delta$SOC, and a temperature T. In this case, the Comparator and corrector 36 multiplies parameters of the current rate R, the $\Delta$SOC, and the temperature T by an associated reduction rate of the $\Delta$SOC, and derives the value obtained by multiplication as a reduction rate of the $\Delta$SOC. The Comparator and corrector 36 corrects the parameters of the battery capacity C of the battery module 12 so that a value obtained by multiplying the $\Delta$SOC by the reduction rate is corrected to be 0.

For example, when the current rate R is 1/2C, the $\Delta$SOC is 40%, and the temperature is 10 to 20 °C in the numerical examples of Figs. 6, 12, and 15 described above, the Comparator and corrector 36 derives a value (= 1/10) obtained by multiplying 1/2, 0.4, and 1/2 as a reduction rate of the $\Delta$SOC. The Comparator and corrector 36 corrects the parameters of the battery capacity C of the battery module 12 so that the derived $\Delta$SOC is 9/10.

According to the storage system 1 in the above-described third embodiment, like in the second embodiment, a correction quantity of the battery capacity C is changed on the basis of the use state of the battery module 12 so that the SOC of the battery module 12 can be estimated with higher accuracy.

Other examples (modified examples) will be described below.

Although a case in which the voltmeters 22, the first SOC deriver 24, the ammeter 32, and the second SOC deriver 34 perform various measurements and derivation of an SOC on each of the battery modules 12 has been described in the above-described embodiment, the present invention is not limited thereto. For example, a voltage and a current between terminals may be measured for each assembled battery unit 10, and various SOCs may be derived for each assembled battery unit 10 on the basis of the measured voltage current.

According to at least one of the above-described embodiments, an $SOC_{1b}$ is derived on the basis of a static voltage of the battery module 12 acquired at a timing at which the voltage is static before charging and discharging of electricity and OCV-SOC characteristics data, an $SOC_2$ is derived on the basis of a current integrated value $\int I$ of the battery module 12 during charging and discharging of electricity, a battery capacity C of the battery module 12, and a derived $SOC_{1b}$, an $SOC_{1a}$ is derived on the basis of the static voltage of the battery module 12 acquired at the timing at which the voltage is static after charging and discharging of electricity and the OCV-SOC characteristics data, and parameters of the battery capacity C of the battery module 12 are corrected on the basis of a difference $\Delta SOC$ between the $SOC_2$ and the $SOC_{1a}$. As a result, the storage system 1 can estimate the SOC of the battery module 12 with high accuracy.

Although several embodiments of the present invention have been described, such embodiments are presented as examples and are not intended to limit the scope of the invention. Such embodiments can be implemented in various other forms, and various omissions, substitutions, and modifications can be made without departing from the gist of the invention. Such embodiments and modifications thereof are included in the scope and the gist of the invention as well as being included within the invention described in the claims and the equivalent scope thereof.

[Reference Signs List]

1 Storage system
10, 10(1) to 10(k) Assembled battery unit
12, 12(1) to 12(k) Battery module
20, 20(1) to 20(k) CMU
22, 22(1) to 22(k) Voltmeter
24, 24(1) to 24(k) First SOC deriver
26, 26(1) to 26(k) Thermometer
30 BMU
32 Ammeter
34 Second SOC deriver
36 Comparator and corrector
40 High-order device
50 PCS
60 Electric power system
70 Switch circuit

72 Switch

**Claims**

1. A storage system comprising:

   a storage battery configured to perform charging and discharging of electricity;
   a first deriver configured to derive a first state of charge (SOC) on the basis of a voltage of the storage battery when a current is not flowing to the storage battery;
   a second deriver configured to derive a second SOC on the basis of a battery capacity of the storage battery and an integrated value of a current flowing to the storage battery; and
   a corrector configured to correct the battery capacity which is used by the second deriver on the basis of a difference between the second SOC derived by the second deriver and the first SOC derived by the first deriver after the derivation of the second SOC, which changes a correction quantity of the correction in accordance with a state of the storage battery.

2. The storage system according to claim 1, wherein the state of the storage battery includes at least one of a difference between the first SOC and the second SOC, a current rate of the storage battery, and a temperature of the storage battery.

3. The storage system according to claim 1 or 2, wherein the corrector multiplies a reduction rate according to the state of the storage battery by the difference between the first SOC and the second SOC to correct the battery capacity of the storage battery.

4. A storage control method including, performing using a computer configured to control a storage battery,
   deriving a first SOC on the basis of a voltage of the storage battery when a current is not flowing to the storage battery;
   deriving a second SOC on the basis of a battery capacity of the storage battery and an integrated value of a current flowing to the storage battery; and
   correcting the battery capacity of the storage battery which is used on the basis of the derived second SOC and the first SOC derived after the derivation of the second SOC and changing a correction quantity of the correction in accordance with a state of the storage battery.

5. A storage control program causing a computer configured to control a storage battery
   to derive a first SOC on the basis of a voltage of the storage battery when a current is not flowing to the storage battery;

to derive a second SOC on the basis of a battery capacity of the storage battery and an integrated value of a current flowing to the storage battery; and

to correct the battery capacity of the storage battery which is used on the basis of the derived second SOC and the first SOC derived after the derivation of the second SOC and to change a correction quantity of the correction in accordance with a state of the storage battery.

FIG. 1

EP 3 264 119 A1

FIG. 2

EP 3 264 119 A1

# FIG. 3

# FIG. 4

# FIG. 5

```
            START
              │
    ┌─────────────────────┐
    │   DERIVE SOC₁ᵦ       │──── S100
    └─────────────────────┘
              │
    ┌─────────────────────────────┐
    │ CHARGE AND DISCHARGE ELECTRICITY │──── S102
    └─────────────────────────────┘
              │
    ┌─────────────────────────────┐
    │ DERIVE CURRENT INTEGRATED VALUE ∫I │──── S104
    └─────────────────────────────┘
              │
    ┌─────────────────────┐
    │   DERIVE SOC₂        │──── S106
    └─────────────────────┘
              │
    ┌─────────────────────┐
    │   DERIVE SOC₁ₐ       │──── S108
    └─────────────────────┘
              │
    ┌─────────────────────┐
    │   DERIVE ΔSOC        │──── S110
    └─────────────────────┘
              │          S112
              ▼
         ╱──────────╲        NO
        ⟨  ΔSOC≠0?   ⟩───────────┐
         ╲──────────╱           │
              │ YES             │
    ┌─────────────────────┐     │
    │ CORRECT BATTERY CAPACITY C │──── S114
    └─────────────────────┘     │
              │◄────────────────┘
              ▼
            RETURN
```

$DERIVE\ SOC_{1b}$ — S100

$CHARGE\ AND\ DISCHARGE\ ELECTRICITY$ — S102

$DERIVE\ CURRENT\ INTEGRATED\ VALUE\ \int I$ — S104

$DERIVE\ SOC_2$ — S106

$DERIVE\ SOC_{1a}$ — S108

$DERIVE\ \Delta SOC$ — S110

$\Delta SOC \neq 0?$ — S112

$CORRECT\ BATTERY\ CAPACITY\ C$ — S114

FIG. 6

| CURRENT RATE R | REDUCTION RATE OF ΔSOC |
|---|---|
| 1/n·C | 1/n |
| ... | ... |
| 1/4C | 1/4 |
| 1/2C | 1/2 |
| 1C(REFERENCE VALUE) | 1 |
| 2C | 1/2 |
| 4C | 1/4 |
| ... | ... |
| mC | 1/m |

FIG. 7

FIG. 8

REDUCTION
RATE OF △SOC

1

REFERENCE
VALUE

△C

LN4

CURRENT RATE R

FIG. 9

REDUCTION
RATE OF △SOC

1

Th1

REFERENCE
VALUE

△C

Th2

LN5

CURRENT RATE R

# FIG. 10

REDUCTION
RATE OF △SOC

REFERENCE VALUE          CURRENT RATE R

# FIG. 11

REDUCTION
RATE OF △SOC

REFERENCE VALUE          CURRENT RATE R

# FIG. 12

| $\Delta SOC_{1a-1b}$ [%] | REDUCTION RATE OF $\Delta SOC$ |
|---|---|
| 100 (REFERENCE VALUE) | 1 |
| 90 | 0.9 |
| 80 | 0.8 |
| 70 | 0.7 |
| 60 | 0.6 |
| 50 | 0.5 |
| 40 | 0.4 |
| 30 | 0.3 |
| 20 | 0.2 |
| 10 | 0.1 |

# FIG. 13

START

S200
ARE PARAMETERS REFERENCE VALUE?

NO

YES

S202
REDUCTION RATE IS DECIDED TO BE 1

S204
CHANGE REDUCTION RATE

S206
CORRECT BATTERY CAPACITY C ON THE BASIS OF REDUCTION RATE

END

FIG. 14

## FIG. 15

| TEMPERATURE T [°C] | REDUCTION RATE OF $\Delta$SOC |
|---|---|
| . . . | . . . |
| −20~−10 | 1/16 |
| −10~0 | 1/8 |
| 0~10 | 1/4 |
| 10~20 | 1/2 |
| 20~30 (REFERENCE RANGE$\Delta$T) | 1 |
| 30~40 | 1/2 |
| 40~50 | 1/4 |
| . . . | . . . |

## INTERNATIONAL SEARCH REPORT

International application No.

PCT/JP2015/054650

| A. CLASSIFICATION OF SUBJECT MATTER |
|---|
| G01R31/36(2006.01)i |

According to International Patent Classification (IPC) or to both national classification and IPC

| B. FIELDS SEARCHED |
|---|
| Minimum documentation searched (classification system followed by classification symbols) |
| G01R31/36 |

Documentation searched other than minimum documentation to the extent that such documents are included in the fields searched
Jitsuyo Shinan Koho          1922–1996   Jitsuyo Shinan Toroku Koho   1996–2015
Kokai Jitsuyo Shinan Koho    1971–2015   Toroku Jitsuyo Shinan Koho   1994–2015

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X<br>Y | JP 2010-019595 A  (Fuji Heavy Industries Ltd.),<br>28 January 2010 (28.01.2010),<br>paragraphs [0011] to [0043]; fig. 1 to 3, 5, 13<br>(Family: none) | 1-5<br>2 |
| X<br>Y | JP 2014-169937 A  (Denso Corp.),<br>18 September 2014 (18.09.2014),<br>paragraphs [0030] to [0035], [0062]; fig. 1 to 3<br>(Family: none) | 1-2,4-5<br>2 |
| Y | JP 2013-108919 A  (Toyota Industries Corp.),<br>06 June 2013 (06.06.2013),<br>paragraph [0034]<br>(Family: none) | 2 |

☐ Further documents are listed in the continuation of Box C.     ☐ See patent family annex.

| * | Special categories of cited documents: |
|---|---|
| "A" | document defining the general state of the art which is not considered    to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 22 April 2015 (22.04.15) | 12 May 2015 (12.05.15) |

| Name and mailing address of the ISA/<br>Japan Patent Office<br>3-4-3,Kasumigaseki,Chiyoda-ku,<br>Tokyo 100-8915,Japan | Authorized officer |
|---|---|
| | Telephone No. |

Form PCT/ISA/210 (second sheet) (July 2009)

21

**EP 3 264 119 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000306613 A
- JP 2014174050 A